# EUROPEAN PATENT APPLICATION

(11) **EP 4 412 072 A1**
(43) Date of publication of application: **07.08.2024**
(21) Application number: 22875445.3
(22) Date of filing: 20.05.2022
(51) Int. Cl.: H02M 7/48, H02M 7/493

(54) **ELECTRIC POWER CONVERSION DEVICE, AND ELECTRIC POWER CONVERSION METHOD**

(30) Priority: 30.09.2021 JP 2021160904
(71) Applicant: Hitachi, Ltd., Tokyo 100-8280 (JP)
(72) Inventor: ENDO, Shun, Tokyo 100-8280 (JP); SHIMADA, Takae, Tokyo 100-8280 (JP); ANDO, Masato, Tokyo 100-8280 (JP); HIRUTA, Kiyoharu, Tokyo 101-8941 (JP); TAKAYAMA, Naoki, Tokyo 101-8941 (JP); SEKI, Masaki, Tokyo 101-8941 (JP)
(74) Representative: MERH-IP Matias Erny Reichl Hoffmann Patentanwälte PartG mbB
(86) International application number: PCT/JP2022/020933
(87) International publication number: WO 2023/053565

(57) **Abstract**

Provided is a power conversion device including a plurality of switching elements connected in parallel, the power conversion device suppressing temperature imbalance due to delay time variation and temperature imbalance due to on-voltage variation. A power conversion device including a plurality of switching elements; a temperature sensor that detects temperatures of the plurality of switching elements; a carrier frequency adjusting unit that adjusts carrier frequencies of the plurality of switching elements; a delay time adjusting unit that adjusts turn-on times or turn-off times of the plurality of switching elements; and a gate voltage adjusting unit that adjusts on-voltages of the plurality of switching elements, in which the temperature sensor detects a change amount of a temperature difference between the plurality of switching elements before and after carrier frequency adjustment by the carrier frequency adjusting unit, and the delay time adjusting unit adjusts turn-on times or turn-off times of the plurality of switching elements on the basis of the detected change amount of the temperature difference.

## Description

### Technical Field

The present invention relates to a configuration of a power conversion device and control of the power conversion device, and particularly relates to a technique that is effective when applied to a large-capacity power conversion device configured by connecting a plurality of power conversion units in multiple parallel.

### Background Art

A power conversion device can convert DC power into AC power or a reverse direction thereof by a switching operation of a power semiconductor element, and is applied to various fields such as elevators, railways, and automobiles.

In order to respond to various applications, it has been proposed to use a power conversion system capable of outputting a large current by connecting a plurality of power conversion devices (power conversion units) in parallel. For example, such a power conversion system has a common drive signal supplied to a plurality of power conversion devices connected in parallel, and is driven so that the plurality of power conversion devices output equal currents. However, variations in components such as wirings and elements constituting the power conversion devices may cause variations in the output currents of the power conversion devices.

For example, since the power semiconductor element has characteristic variations unique to the power semiconductor element, such as a turn-on delay time, a turn-off delay time, and an on-voltage, when the power semiconductor elements are connected in parallel, a current value flowing through each power semiconductor element becomes unbalanced. Therefore, the current concentrates on some power semiconductor elements, and the switching loss and the conduction loss increase, and a temperature imbalance occurs. The temperature imbalance affects not only output characteristics such as an output current of the power conversion device but also reliability and life of the power conversion device.

Conventionally, when power semiconductor elements are connected in parallel, it is necessary to design the power semiconductor elements with a current value smaller than the rated current of each of the power semiconductor elements in consideration of such unbalance. Therefore, the performance of the power semiconductor element cannot be utilized to the maximum.

Therefore, PTL 1 discloses "A current balance adjustment circuit comprising: an output current difference calculation circuit that outputs a difference result between an output current value and a reference value when a polarity of the output current value is positive, and outputs a difference between an absolute value of the output current value and an absolute value of the reference value when the polarity of the output current value is negative, for each of output current values of a plurality of power conversion devices connected in parallel to each other and driven on the basis of a common ON signal; and an adjustment time calculation circuit that outputs an adjustment time signal indicating a delay time amount at a rising timing or a falling timing of the common ON signal according to an output value of the output current difference calculation circuit".

### Citation List

### Patent Literature

PTL 1: JP 2018-153087 A

### Summary of Invention

### Technical Problem

Patent Literature 1 described above is a technique for suppressing one of temperature imbalance due to delay time variation and temperature imbalance due to on-voltage variation, and effects of reduction of switching loss and conduction loss and reduction of temperature imbalance are limited.

Therefore, an object of the present invention is to provide a power conversion device and a power conversion method that suppress temperature imbalance due to delay time variation and temperature imbalance due to on-voltage variation in a power conversion device including a plurality of switching elements connected in parallel.

Another object of the present invention is to provide a power conversion device and a power conversion method that suppress temperature imbalance due to delay time variation and temperature imbalance due to on-voltage variation in a power conversion device including a plurality of power conversion units connected in parallel.

### Solution to Problem

In order to solve the above problems, the present invention provides a power conversion device including: a plurality of switching elements; a temperature sensor that detects temperatures of the plurality of switching elements; a carrier frequency adjusting unit that adjusts carrier frequencies of the plurality of switching elements; a delay time adjusting unit that adjusts turn-on times or turn-off times of the plurality of switching elements; and a gate voltage adjusting unit that adjusts on-voltages of the plurality of switching elements, in which the temperature sensor detects a change amount of a temperature difference between the plurality of switching elements before and after carrier frequency adjustment by the carrier frequency adjusting unit, and the delay time adjusting unit adjusts turn-on times or turn-off times of the plurality of switching elements on a basis of the detected change amount of the temperature difference.

Further, the present invention is characterized by including: (a) a step of detecting a temperature difference among a plurality of switching elements at a predetermined carrier frequency; (b) a step of changing a carrier frequency after the step (a); (c) a step of detecting a temperature difference among the plurality of switching elements at a changed carrier frequency after the step (b); (d) a step of calculating a change amount between the temperature difference detected in the step (a) and the temperature difference detected in the step (c) after the step (c); and (e) a step of determining whether or not adjustment of turn-on times or turn-off times of the plurality of switching elements is necessary on the basis of the calculated change amount of the temperature difference after the step (d).

### Advantageous Effects of Invention

According to the present invention, it is possible to realize a power conversion device and a power conversion method that suppress a temperature imbalance due to a delay time variation and a temperature imbalance due to an on-voltage variation in a power conversion device including a plurality of switching elements connected in parallel.

In addition, in a power conversion device including a plurality of power conversion units connected in parallel, it is possible to realize a power conversion device and a power conversion method that suppress temperature imbalance due to delay time variation and temperature imbalance due to on-voltage variation.

The problems, configurations, and effects other than those described above will be clarified from the description of the embodiments below.

### Brief Description of Drawings

[FIG. 1] FIG. 1 is a diagram illustrating a schematic configuration of an elevator system according to a first embodiment of the present invention.
[FIG. 2] FIG. 2 is a diagram illustrating a configuration of an inverter system 11 of Fig. 1 and a drive circuit thereof.
[FIG. 3] FIG. 3 is a diagram illustrating an operation waveform when a variation in turn-on delay occurs according to the embodiment of the present invention.
[FIG. 4] FIG. 4 is a diagram illustrating an operation waveform when a variation in turn-off delay occurs according to an embodiment of the present invention.
[FIG. 5] FIG. 5 is a diagram illustrating an operation waveform at a low carrier frequency according to the embodiment of the present invention.
[FIG. 6] FIG. 6 is a diagram illustrating an operation waveform at a high carrier frequency according to the embodiment of the present invention.
[FIG. 7] FIG. 7 is a diagram illustrating an operation waveform at the time of on-voltage variation according to the embodiment of the present invention.
[FIG. 8] FIG. 8 is a diagram illustrating gate voltage dependency of a collector current characteristic with respect to a collector-emitter voltage in a switching element according to the embodiment of the present invention.
[FIG. 9] FIG. 9 is a flowchart illustrating a temperature imbalance reduction method according to the first embodiment of the present invention.

### Description of Embodiments

Hereinafter, embodiments of the present invention will be described with reference to the drawings. In the drawings, the same components are denoted by the same reference numerals, and the detailed description of overlapping portions is omitted.

### First embodiment

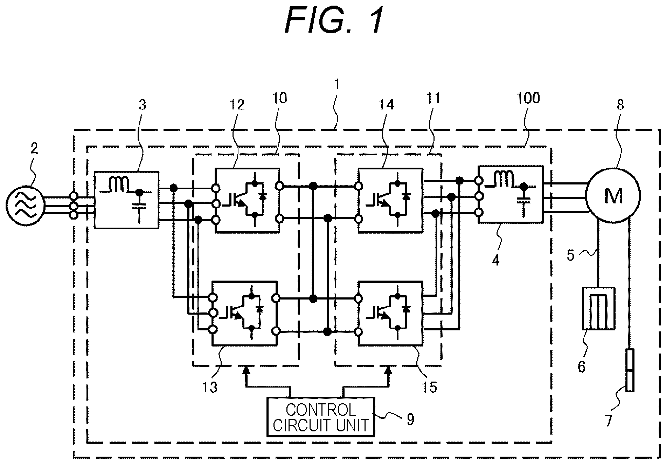

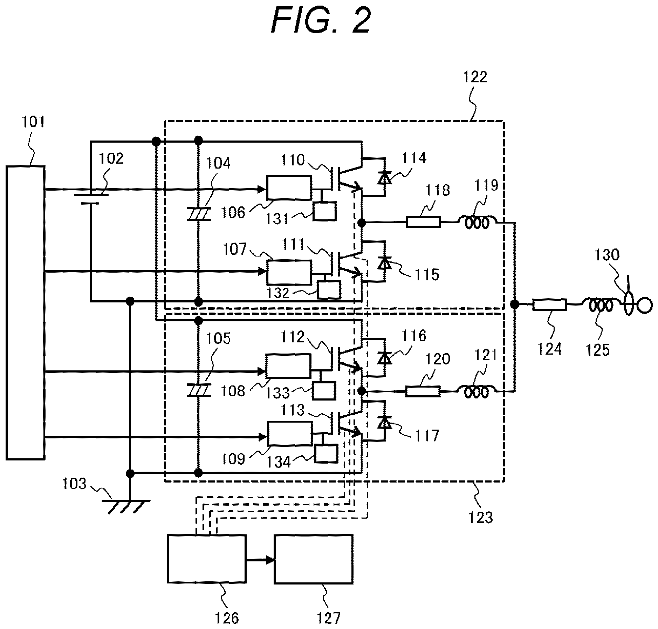

First, a configuration of a power conversion device according to a first embodiment of the present invention will be described with reference to FIGS. 1 and 2.

FIG. 1 is a diagram illustrating a schematic configuration of an elevator system 1 which is an application example of a power conversion device 100 of the present embodiment. FIG. 2 is a diagram illustrating a configuration of an inverter system 11 of FIG. 1 and a drive circuit thereof.

As illustrated in FIG. 1, the elevator system 1 of the present embodiment includes, as main components, a rope 5, a car 6, a weight 7, a motor 8, and a power conversion device 100. In the elevator system 1, the three-phase AC power supplied from a system 2 is input to a plurality of three-phase converter systems 10 connected in parallel via a filter circuit 3, and the converter system 10 performs power conversion from AC to DC via power conversion units 12 and 13.

Then, a three-phase inverter system 11 in which a plurality of power conversion units 14 and 15 are connected in parallel drives the motor 8 via the filter circuit 4. The converter system 10 and the inverter system 11 are controlled by a control circuit unit 9.

As a load of the motor 8, there are a car 6 of the elevator connected to the rope 5 and a weight 7 for balancing with the car 6. The power of the motor 8 is consumed to raise and lower the elevator car 6.

The inverter system 11 of FIG. 1 will be described with reference to FIG. 2. The inverter system 11 includes, as main components, a plurality of (two in FIG. 2) power conversion units 122,123, a temperature detecting circuit 126, and a carrier frequency (switching frequency) adjusting unit 127.

The power conversion units 122,123 are connected in parallel, input sides of the power conversion units 122,123 are connected in parallel to a converter system 10 (not illustrated), and output sides are connected to output loads 124,125 of the power conversion device 100. A current sensor 130 is attached to the output of the power conversion device 100.

The power conversion unit 122 includes an upper arm switching element 110, a lower arm switching element 111, an upper arm switching freewheeling diode 114, and a lower arm switching freewheeling diode 115, and a resistor 118 and a reactor 119 are connected to an output thereof. As a gate circuit, delay time adjusting units 106,107 and gate voltage adjusting units 131,132 are connected to the upper arm switching element 110 and the lower arm switching element 111, respectively.

The power conversion unit 123 includes an upper arm switching element 112, a lower arm switching element 113, an upper arm switching freewheeling diode 116, and a lower arm switching freewheeling diode 117, and a resistor 120 and a reactor 121 are connected to an output thereof. As a gate circuit, delay time adjusting units 108,109 and gate voltage adjusting units 133,134 are connected to the upper arm switching element 112 and the lower arm switching element 113, respectively.

Control signals are output from an input signal 101 and input to the delay time adjusting units 106,107,108,109.

A temperature sensor (not illustrated) is disposed on each of the upper and lower arms of the power conversion unit 122, detects the temperature of each of the upper arm switching element 110 and the lower arm switching element 111, and inputs detected temperature information to the temperature detecting circuit 126.

In addition, temperature sensors (not illustrated) are arranged in the upper and lower arms of the power conversion unit 123, respectively, to detect the temperatures of the upper arm switching element 112 and the lower arm switching element 113, and input detected temperature information to the temperature detecting circuit 126.

A carrier frequency adjusting unit 127, the delay time adjusting units 106 to 109, and the gate voltage adjusting units 131 to 134 are adjusted via the temperature detecting circuit 126.

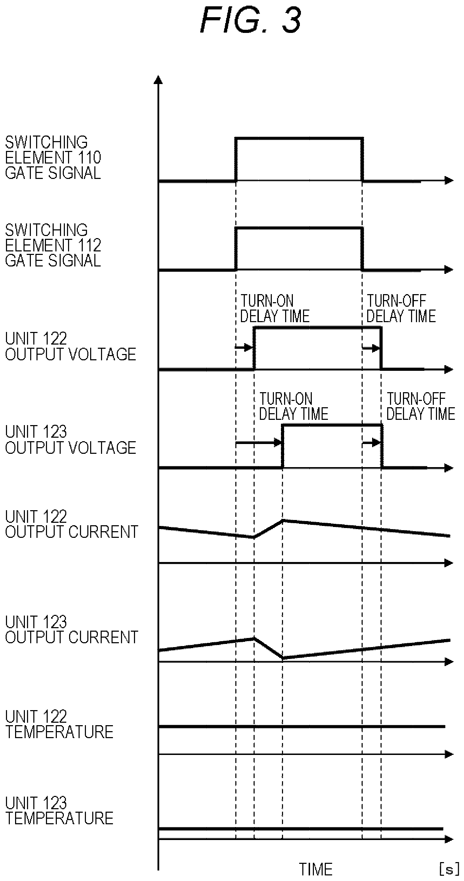

Next, the operation of the power conversion device will be described with reference to FIGS. 3 to 8.

FIG. 3 is an operation waveform when a variation in turn-on delay time occurs in the switching element. In FIG. 3, the horizontal axis represents time [s], and the vertical axis represents the gate signal of the switching element 110, the gate signal of the switching element 112, the output voltage of the power conversion unit 122, the output voltage of the power conversion unit 123, the output current of the power conversion unit 122, the output current of the power conversion unit 123, the temperature of the power conversion unit 122, and the temperature of the power conversion unit 123 in order from the top.

When the same gate signal is input to the switching elements 110,112, since the turn-on delay time varies, the pulse width of the output voltage of the power conversion unit 123 becomes narrower than that of the power conversion unit 122. As a result, the time during which a voltage is applied to the resistor 118 and the reactor 119 of the power conversion unit 122 becomes longer than the time during which a voltage is applied to the resistor 120 and the reactor 121 of the power conversion unit 123, and the output current of the power conversion unit 122 becomes larger than that of the power conversion unit 123. As a result, the current flowing through the switching element 110 of the power conversion unit 122 becomes larger than the current flowing through the switching element 112 of the power conversion unit 123. Since the switching element has an on-resistance, the larger the flowing current, the larger the heat generation, and the temperature of the power conversion unit 122 becomes larger than that of the power conversion unit 123.

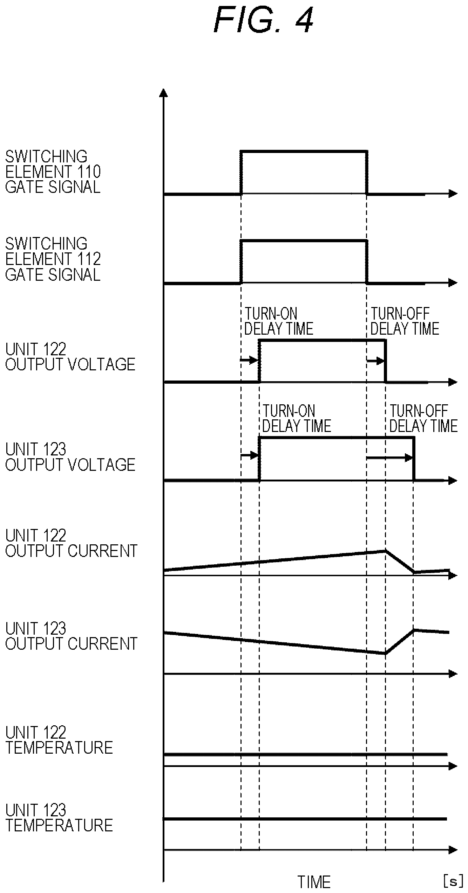

FIG. 4 is an operation waveform when a variation in turn-off delay time occurs in the switching element.

When the same gate signal is input to the switching elements 110,112, since the turn-off delay time varies, the pulse width of the output voltage of the power conversion unit 122 becomes narrower than that of the unit 123. As a result, the time during which a voltage is applied to the resistor 118 and the reactor 119 of the power conversion unit 122 becomes shorter than the time during which a voltage is applied to the resistor 120 and the reactor 121 of the power conversion unit 123, and the output current of the power conversion unit 122 becomes smaller than that of the power conversion unit 123. As a result, the current flowing through the switching element 110 of the power conversion unit 122 becomes smaller than the current flowing through the switching element 112 of the power conversion unit 123. Since the switching element has an on-resistance, the larger the flowing current, the larger the heat generation, and the temperature of the power conversion unit 122 becomes smaller than that of the power conversion unit 123.

As described above, when the output current between the power conversion units connected in parallel becomes unbalanced, the current concentrates on some power semiconductor elements, the switching loss and the conduction loss increase, and temperature imbalance occurs.

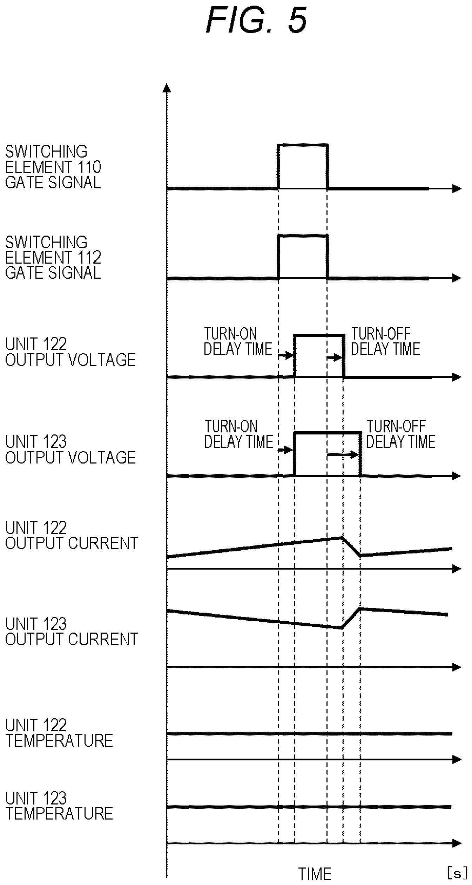

FIG. 5 is an operation waveform when a variation in turn-off delay time occurs and the carrier frequency is low.

When the turn-off delay time varies, the time during which a voltage is applied to the resistor 118 and the reactor 119 of the power conversion unit 122 is shorter than the time during which a voltage is applied to the resistor 120 and the reactor 121 of the unit 123.

When the carrier frequency is low, the number of pulses of the output voltage per second also decreases, and the difference between the time during which the voltage is applied to the resistor 118 and the reactor 119 of the power conversion unit 122 and the time during which the voltage is applied to the resistor 120 and the reactor 121 of the unit 123 becomes shorter than the time when the number of pulses is large.

As a result, the temperature imbalance becomes smaller than that when the carrier frequency is high and the number of pulses is large. Here, since the difference in pulse width becomes the current imbalance, the current imbalance decreases when the carrier frequency is low also in the turn-on delay.

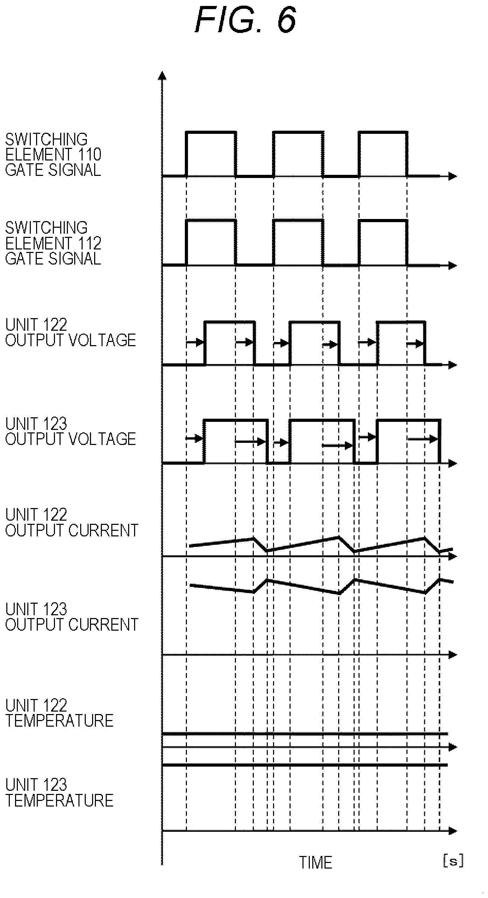

FIG. 6 is an operation waveform when a variation in turn-off delay time occurs and the carrier frequency is high.

When the turn-off delay time varies, the time during which a voltage is applied to the resistor 118 and the reactor 119 of the power conversion unit 122 is shorter than the time during which a voltage is applied to the resistor 120 and the reactor 121 of the unit 123.

When the carrier frequency is high, the number of pulses of the output voltage per second increases, and the difference between the time during which the voltage is applied to the resistor 118 and the reactor 119 of the power conversion unit 122 and the time during which the voltage is applied to the resistor 120 and the reactor 121 of the power conversion unit 123 is longer than the time when the number of pulses is small.

As a result, the temperature imbalance becomes larger than that when the carrier frequency is low and the number of pulses is small. Here, since the difference in pulse width becomes the current imbalance, the current imbalance increases when the carrier frequency is high also in the turn-on delay.

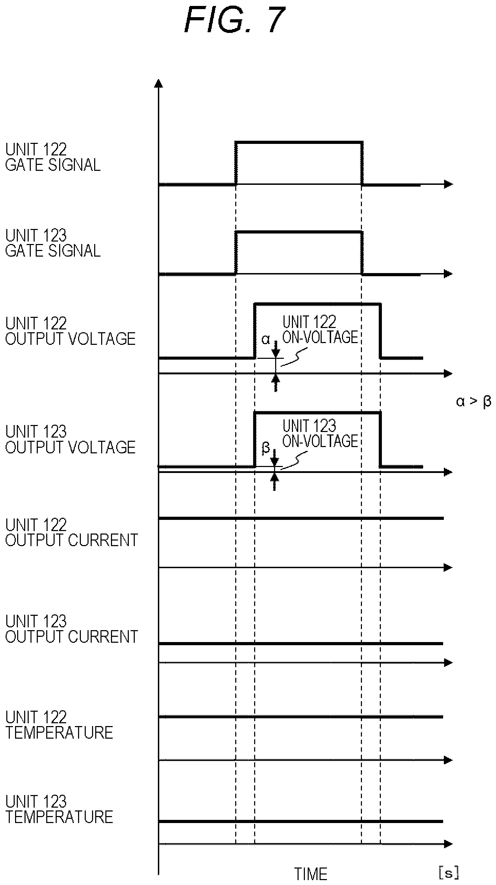

FIG. 7 is an operation waveform when on-voltage variation occurs in the switching element.

When an on-voltage α of the power conversion unit 122 is larger than an on-voltage β of the power conversion unit 123, the voltage applied to the resistor 118 and the reactor 119 of the power conversion unit 122 is higher than the voltage applied to the resistor 120 and the reactor 121 of the power conversion unit 123. Therefore, the output current and temperature of the power conversion unit 122 become larger than those of the power conversion unit 123.

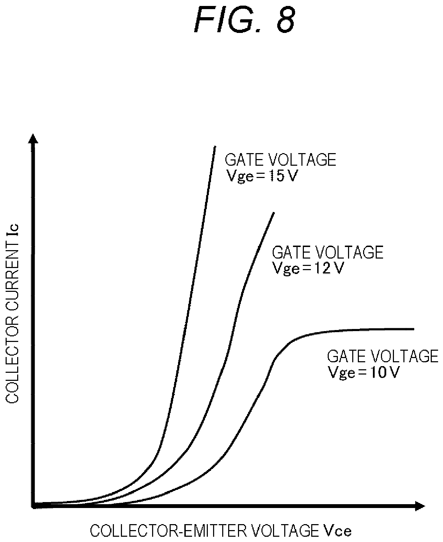

FIG. 8 illustrates a gate voltage dependency of the collector current characteristic with respect to the collector-emitter voltage of the switching element.

When the gate voltage is high even with the same collector current, the collector-emitter voltage is lower than that when the gate voltage is low. The on-voltage of the switching element can be adjusted by changing the voltage applied to the gate by each of the gate voltage adjusting units 131 to 134.

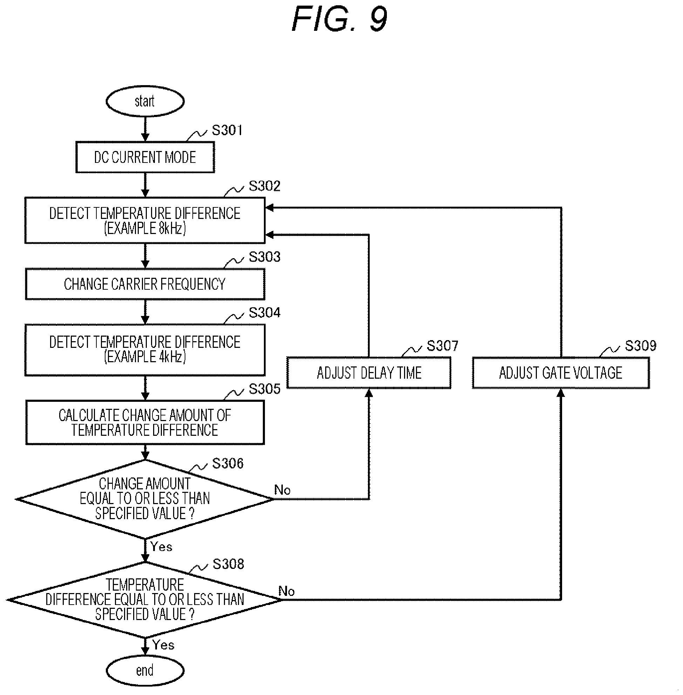

A temperature imbalance reduction method according to the present embodiment will be described with reference to FIG. 9.

First, in step S301, adjustment is started during the DC current output mode. The DC current output mode corresponds to the activation compensation mode of the elevator system 1 illustrated in FIG. 1.

Next, in step S302, a temperature difference between the plurality of switching elements (power semiconductor elements) is detected at a carrier frequency of 8 kHz, for example.

Subsequently, in step S303, the carrier frequency is changed, and in step S304, the temperature difference between the plurality of switching elements (power semiconductor elements) is detected again at the carrier frequency of 4 kHz, for example.

Thereafter, in step S305, a change amount is calculated from the temperature difference before and after the change.

Next, in step S306, it is determined whether or not the change amount is equal to or less than a specified value.

In a case where it is determined in step S306 that the change amount is larger than the specified value (No), the process proceeds to step S307, the delay times of the switching elements 110 to 113 are adjusted by the delay time adjusting units 106 to 109, respectively, and then the process proceeds to step S302. The cross current due to the delay time is suppressed by repeating steps S302 to S307 until the change amount becomes equal to or less than the specified value.

On the other hand, in a case where it is determined that the change amount is equal to or less than the specified value (Yes), the process proceeds to step S308, and it is determined whether or not the temperature difference is equal to or less than a specified value.

In a case where it is determined in step S308 that the temperature difference is equal to or less than the specified value (Yes), the process ends.

On the other hand, when it is determined that the temperature difference is larger than the specified value (No), the process proceeds to step S309, and the gate voltage adjusting units 131 to 134 adjust the gate voltages of the switching elements 110 to 113. At this time, since the delay time also changes due to the gate voltage adjustment, the process returns to step S302 again, and the temperature difference is suppressed by repeating steps S302 to S309.

As described above, by changing the carrier frequency to separate the temperature imbalance due to the turn-on delay time and the turn-off delay time and the temperature imbalance due to the on-voltage, the delay time and the gate voltage can be appropriately adjusted, and the temperature imbalance can be minimized.

Note that the present invention is not limited to the above-described embodiments, and includes various modifications. For example, the above-described embodiments have been described in detail in order to explain the present invention in an easy-to-understand manner, and are not necessarily limited to those having all the described configurations. In addition, a part of the configuration of a certain embodiment can be replaced with the configuration of another embodiment, and the configuration of another embodiment can be added to the configuration of a certain embodiment. In addition, it is possible to add, delete, and replace other configurations for a part of the configuration of each embodiment.

### Reference Signs List

1 elevator system
2 system
3, 4 filter circuit
5 rope
6 car
7 weight
8 motor
9 control circuit unit
10 converter system
11 inverter system
12 to 15 power conversion unit
100 power conversion device
101 input signal
102 DC power supply
103 GND
104, 105 capacitor
106 to 109 delay time adjusting unit
110, 112 upper arm switching element
111, 113 lower arm switching element
114, 116 upper arm switching freewheeling diode
115, 117 lower arm switching freewheeling diode
118, 120 resistor
119, 121 reactor
122, 123 power conversion unit
124, 125 output load
126 temperature detecting circuit w
127 carrier frequency (switching frequency) adjusting unit
130 current sensor
131 to 134 gate voltage adjusting unit

## Claims

1. A power conversion device comprising:
a plurality of switching elements;
a temperature sensor that detects temperatures of the plurality of switching elements;
a carrier frequency adjusting unit that adjusts carrier frequencies of the plurality of switching elements;
a delay time adjusting unit that adjusts turn-on times or turn-off times of the plurality of switching elements; and
a gate voltage adjusting unit that adjusts on-voltages of the plurality of switching elements,
wherein the temperature sensor detects a change amount of a temperature difference between the plurality of switching elements before and after carrier frequency adjustment by the carrier frequency adjusting unit, and
the delay time adjusting unit adjusts turn-on times or turn-off times of the plurality of switching elements on a basis of the detected change amount of the temperature difference.

2. The power conversion device according to claim 1, wherein the detection of the change amount of the temperature difference by the temperature sensor and the adjustment of the turn-on times or the turn-off times of the plurality of switching elements by the delay time adjusting unit are repeated until the change amount of the temperature difference becomes equal to or less than a predetermined value.

3. The power conversion device according to claim 2, wherein after the adjustment of the turn-on times or the turn-off times of the plurality of switching elements, when the change amount of the temperature difference is equal to or less than a predetermined value and the temperature difference is equal to or more than a predetermined value, the gate voltage adjusting unit adjusts the on-voltages of the switching elements.

4. The power conversion device according to claim 3, wherein until the temperature difference becomes equal to or less than a predetermined value, adjustment of turn-on times or turn-off times of the plurality of switching elements by the delay time adjusting unit and adjustment of on-voltages of the plurality of switching elements by the gate voltage adjusting unit are repeated.

5. The power conversion device according to claim 1, wherein
the plurality of switching elements include:
upper arm switching elements constituting an upper arm of the power conversion device; and
lower arm switching elements connected in parallel with the upper arm switching elements and constituting a lower arm of the power conversion device, and
the temperature sensor detects temperature differences between the upper arm switching elements and the lower arm switching elements.

6. The power conversion device according to claim 1, further comprising:
a first power conversion unit including a plurality of switching elements; and
a second power conversion unit connected in parallel with the first power conversion unit and including a plurality of switching elements,
wherein the temperature sensor detects a temperature difference between the first power conversion unit and the second power conversion unit.

7. The power conversion device according to claim 1, wherein
the power conversion device is mounted in an elevator system, and
the detection of a change amount of a temperature difference between the plurality of switching elements by the temperature sensor and the adjustment of the turn-on times or the turn-off times of the plurality of switching elements by the delay time adjusting unit are performed during an activation compensation mode of the elevator system.

8. A power conversion method comprising: (a) a step of detecting a temperature difference among a plurality of switching elements at a predetermined carrier frequency; (b) a step of changing a carrier frequency after the step (a); (c) a step of detecting a temperature difference among the plurality of switching elements at a changed carrier frequency after the step (b); (d) a step of calculating a change amount between the temperature difference detected in the step (a) and the temperature difference detected in the step (c) after the step (c); and (e) a step of determining whether or not adjustment of turn-on times or turn-off times of the plurality of switching elements is necessary on a basis of the calculated change amount of the temperature difference after the step (d).

9. The power conversion method according to claim 8, wherein in the step (e), when it is determined that the change amount of the calculated temperature difference is larger than a predetermined value, adjustment of turn-on times or turn-off times of the plurality of switching elements is executed.

10. The power conversion method according to claim 9, wherein detection of a change amount of the temperature difference and adjustment of turn-on times or turn-off times of the plurality of switching elements are repeated until the change amount of the temperature difference becomes equal to or less than a predetermined value.

11. The power conversion method according to claim 8, further comprising
(f) a step of determining whether or not adjustment of on-voltages of the plurality of switching elements is necessary on a basis of the temperature difference detected in the step (a),
wherein in the step (e), when it is determined that the change amount of the calculated temperature difference is equal to or less than a predetermined value, the step (f) is executed, and
in the step (f), when it is determined that the temperature difference detected in the step (a) is larger than a predetermined value, adjustment of on-voltages of the plurality of switching elements is executed.

12. The power conversion method according to claim 11, wherein adjustment of turn-on times or turn-off times of the plurality of switching elements and adjustment of on-voltages of the plurality of switching elements are repeated until a temperature difference between the plurality of switching elements becomes equal to or less than a predetermined value.
